(19) Europäisches Patentamt
European Patent Office
Office européen des brevets

(11) **EP 0 475 862 B1**

(12) **FASCICULE DE BREVET EUROPEEN**

(45) Date de publication et mention de la délivrance du brevet:
**06.08.1997 Bulletin 1997/32**

(51) Int Cl.⁶: **H03K 23/66**

(21) Numéro de dépôt: **91420317.9**

(22) Date de dépôt: **10.09.1991**

(54) **Compteur/diviseur rapide et application à un compteur avaleur**

Schneller Zähler/Teiler und dessen Verwendung in einem Zähler mit Impulsunterdrückung

High speed counter/divider and its application in a pulse swallow type counter

(84) Etats contractants désignés:
**DE FR GB IT**

(30) Priorité: **12.09.1990 FR 9011511**

(43) Date de publication de la demande:
**18.03.1992 Bulletin 1992/12**

(73) Titulaire: **SGS-THOMSON MICROELECTRONICS S.A.**
**94250 Gentilly (FR)**

(72) Inventeurs:
• **Jaffard, Jean-Luc**
  **F-38120 Saint Egreve (FR)**
• **Lietar, Loic**
  **F-75019 Paris (FR)**
• **Mouret, Michel**
  **F-38560 Jarry (FR)**

(74) Mandataire: **de Beaumont, Michel**
**1bis, rue Champollion**
**38000 Grenoble (FR)**

(56) Documents cités:
**DD-A- 245 094**          **GB-A- 2 079 999**
**US-A- 4 587 664**

• **PATENT ABSTRACTS OF JAPAN vol. 7, no. 178 (E-191)(1323), 6 août 1983; & JP - A - 5883435**
• **PATENT ABSTRACTS OF JAPAN vol. 12, no. 351 (E-660)(3198), 20 septembre 1988; & JP - A - 63107318**
• **PATENT ABSTRACTS OF JAPAN vol. 12, no. 207 (E-621)(3054), 14 juin 1988; & JP - A - 634717**

## Description

La présente invention concerne un compteur rapide, et plus particulièrement un compteur susceptible de compter des impulsions d'entrée et de fournir une impulsion de sortie chaque fois que l'on a compté une puissance entière de 2 de ces impulsions ou une puissance entière de 2 de ces impulsions plus 1/2 impulsion.

On notera qu'un tel compteur est tout particulièrement utile dans une application à la formation d'un diviseur programmable du type compteur avaleur. Toutefois, la présente invention pourra être susceptible d'autres applications qui apparaîtront à l'homme de l'art.

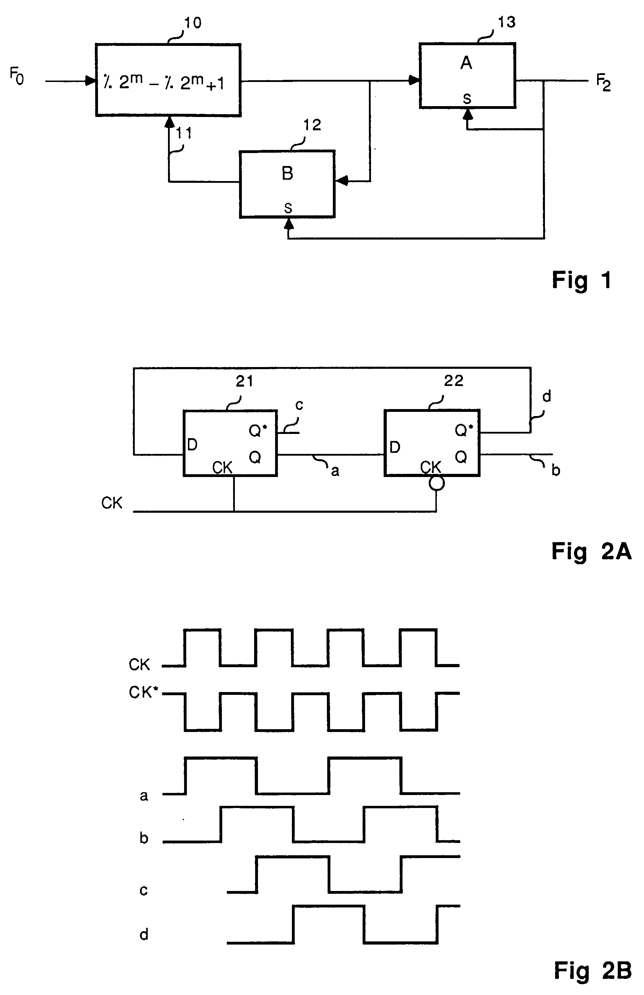

Un diviseur programmable typique du type compteur avaleur est illustré en figure 1.

A titre de clarification initiale de vocabulaire, on notera qu'un compteur jusqu'à une certaine valeur N dont on extrait seulement la N-ième valeur de comptage est équivalent à un diviseur par N. En effet, il fournit une impulsion de sortie toutes les N impulsions d'entrée. Ceci explique que les mots compteur et diviseur seront dans certains cas utilisés indifféremment ici.

Comme le représente la figure 1, un compteur avaleur comprend un diviseur 10 susceptible d'effectuer des divisions par $2^m$ ou par $2^m+1$ selon l'état d'un signal de commande arrivant sur son entrée 11. La sortie du compteur 10 est envoyée en parallèle à un premier compteur 12 et à un deuxième compteur 13. Le compteur 12 compte des impulsions jusqu'à une valeur B et le compteur 13 compte des impulsions jusqu'à une valeur A supérieure à B. Le compteur 13 est connecté pour compter de façon cyclique, c'est-à-dire qu'il reprend son comptage à zéro dès qu'il est arrivé à sa valeur maximale A. Le compteur 12 s'arrête de compter quand il est arrivé à sa valeur de comptage B, jusqu'à ce qu'il soit réinitialisé par le signal de sortie du compteur 13. La sortie du compteur 12 est appliquée à l'entrée 11 du diviseur 10. Les compteurs 12 et 13 sont généralement prévus pour que leurs valeurs de comptage B et A soient programmables en fonction d'un signal de commande envoyé par exemple sur un bus non représenté, d'une façon classique.

Un compteur avaleur du type illustré en figure 1 permet, en fonction du choix des valeurs A et B d'effectuer une division de fréquence par toute valeur choisie non multiple de 2. On désigne par F0 la fréquence d'entrée appliquée au diviseur 10 et par F2 la fréquence obtenue à la sortie du compteur 13. Si l'on veut que F2 = FO/k, on peut écrire :

$$k = A2^m + B,$$

ou

$$k = (A-B)2^m + B(2^m+1).$$

Le circuit de la figure 1 fournit bien F2 = F0/k. En effet, si l'on considère que le compteur 10 est initialement conditionné pour effectuer une division par $2^m+1$, on obtiendra une impulsion à la sortie du compteur 10 toutes les $2^m+1$ périodes de F0 et le compteur 12 fournira une sortie sur la borne 11 quand $B(2^m+1)$ impulsions F0 seront arrivées. Alors, le compteur 12 est inhibé et le diviseur 10 divise par $2^m$. Le compteur 13 a déjà compté B impulsions. Quand les A-B impulsions suivantes auront été obtenues à la sortie du diviseur 10, une impulsion sera fournie à la sortie du compteur 13 et l'on a bien obtenu le facteur de division k souhaité.

On notera que seul le diviseur 10 compte à une cadence rapide, les compteurs 12 et 13 comptant sensiblement à une fréquence $2^m$ fois plus faible que ce compteur. Pour compter des impulsions FO se succédant à une cadence très rapide, il faut donc prévoir un diviseur 10 aussi rapide que possible. Si l'on examine de façon globale le fonctionnement d'un compteur ou d'un diviseur, celui-ci doit effectuer une séquence d'opérations logiques entre deux fronts successifs d'un signal d'horloge. L'arithmétique booléenne enseigne que toute opération logique complexe telle qu'un comptage peut se décomposer en au plus deux niveaux d'opérations logiques élémentaires correspondant à deux commutations de bascule. Pour un diviseur par une valeur autre qu'une puissance entière de 2, il faut en outre prévoir un temps de commutation de bascule supplémentaire pour mémoriser la sortie du diviseur ou une information intermédiaire dans une bascule à mémoire (du type couramment désigné dans la technique par le terme anglosaxon latch). Ainsi, un compteur classique optimisé, autre qu'un diviseur par $2^q$, et notamment un diviseur programmable, nécessite généralement qu'il existe entre deux impulsions à compter le temps nécessaire pour trois commutations de bascule. Dans une technologie donnée de fabrication de circuit intégré, le temps élémentaire de commutation d'une bascule est déterminé et la fréquence maximale de comptage connaît donc une limitation fondamentale (qui est par exemple de l'ordre de 40 MHz en technologie MOS, 2 micromètres, avec une logique de type statique).

Le document PATENTS ABSTRACTS OF JAPAN, vol. 12, no. 351 (E-660) [3198], 20 septembre 1988, & JP-A-63 107 318 divulgue un compteur/diviseur comprenant un premier diviseur fournissant quatre sorties déphasées les unes par rapport aux autres de 360°/4, un multiplexeur muni d'une borne de commande et capable de fournir sur sa sortie séquentiellement chacune desdites quatre sorties chaque fois qu'un signal de commande est appliqué à ladite borne, et un deuxième diviseur recevant la sortie du multiplexeur et fournissant la sortie recherchée du compteur/diviseur, cette sortie étant appliquée à ladite borne. Le premier diviseur étant un diviseur par 4, le compteur/diviseur connu ne fonctionne qu'en diviseur de fréquence par un facteur entier.

Un objet de la présente invention est de prévoir un compteur/diviseur autre que par $2^q$ ne comprenant pas la limitation fondamentale à plusieurs temps de commutation de bascule susmentionnée, et plus particulièrement un tel compteur dont la vitesse limite de fonctionnement est aussi rapide que celle d'un diviseur par $2^q$.

Un autre objet de la présente invention est de prévoir un tel compteur/diviseur susceptible, en fonction de l'application d'un signal de commande, d'effectuer une division par une puissance entière de 2 ou par une puissance de 2 plus 1/2 unité et de passer d'un mode de division à l'autre sans réduction de la vitesse limite de comptage.

Un autre objet de la présente invention est de prévoir un compteur/diviseur rapide insérable dans un circuit de compteur avaleur.

Pour atteindre ces objets ainsi que d'autres, la présente invention prévoit un compteur/diviseur divisant une fréquence d'entrée par $2^{q+n}+1/2$, comprenant : un premier diviseur par $2^q$ recevant le signal à diviser de fréquence F1 et fournissant $2^{q+1}$ sorties à la fréquence $F1/2^q$ déphasées les unes par rapport aux autres de $360°/2^{q+1}$ ; un multiplexeur muni d'une borne de commande et fournissant sur sa sortie séquentiellement chacune des $2^{q+1}$ sorties chaque fois qu'un signal de commande est appliqué ; et un deuxième diviseur par $2^n$ recevant la sortie du multiplexeur et fournissant la sortie recherchée du compteur/diviseur, cette sortie étant appliquée à la borne de commande.

Selon un mode de réalisation de la présente invention, la sortie du deuxième diviseur est fournie à la borne de sortie du compteur/diviseur par l'intermédiaire d'une bascule à mémorisation séquencée par le signal appliqué au deuxième diviseur.

Selon un mode de réalisation de la présente invention, le compteur/diviseur comprend des moyens pour inhiber le fonctionnement du multiplexeur, d'où il résulte qu'une même sortie du premier diviseur est en permanence fournie à l'entrée du deuxième diviseur et que le taux de division du compteur/diviseur est de $2^{q+n}$.

Selon un mode de réalisation de la présente invention, le multiplexeur comprend un troisième diviseur par $2^{q+1}$ dont toutes les sorties sont décodées par un décodeur et appliquées à une bascule à mémorisation dont les sorties commandent séquentiellement $2^{q+1}$ interrupteurs respectivement placés entre chacune des $2^{q+1}$ sorties du premier diviseur et la sortie du multiplexeur.

La présente invention vise également une utilisation d'un compteur/diviseur du type susmentionné en série avec un diviseur par 2 en tant que diviseur d'entrée d'un compteur programmable du type compteur avaleur.

Selon un avantage de la présente invention, on utilise les sorties déphasées d'un premier diviseur fonctionnant à la fréquence la plus rapide et non les sorties successives de ce premier diviseur. Ainsi, le temps de retard entre deux opérations s'écoulant au rythme le plus rapide est seulement le temps correspondant à la génération de deux sorties déphasées d'un même compteur, décalage qui peut être considéré comme égal au temps de commutation d'une seule bascule et non pas de trois bascules comme dans l'art antérieur où l'on considère des comptages successifs d'une même sortie d'un compteur.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1 représente le schéma bloc d'un compteur avaleur selon l'art antérieur ;
la figure 2A et la figure 2B représentent respectivement un schéma de diviseur par 2 et des formes d'onde apparaissant en divers points du circuit de ce diviseur ;
la figure 3 représente, sous forme de schéma bloc un diviseur selon la présente invention ; et
la figure 4 représente un mode d'insertion d'un diviseur selon la présente invention dans un schéma de compteur avaleur.

Avant d'exposer la présente invention, on va rappeler en relation avec les figures 2A et 2B une caractéristique générale des diviseurs, caractéristique généralement non utilisée et dont l'utilisation est à la base de la présente invention.

La figure 2A représente à titre d'exemple un diviseur par 2 constitué à partir de deux bascules de type D 21 et 22. Chacune de ces bascules comprend une entrée D, une entrée d'horloge CK, une sortie Q, et une sortie complémentaire Q*. La sortie Q* de la bascule 22 est rebouclée sur l'entrée D de la bascule 21 et la sortie Q de la bascule 21 est appliquée à l'entrée D de la bascule 22. Un signal d'horloge CK est appliqué à l'entrée CK de la bascule 21 et est appliqué sous forme inversée à l'entrée CK de la bascule 22. On désigne par a le signal à la sortie Q de la bascule 21, par b le signal à la sortie Q de la bascule 22, par c le signal à la sortie Q* de la bascule 21 et par d le signal à la sortie Q* de la bascule 22.

L'allure des signaux CK, CK*, a, b, c et d est illustrée en figure 2B. Les signaux a, b, c, d ont tous la même allure générale d'un signal à fréquence moitié du signal d'horloge mais chacun de ces signaux est déphasé du précédent d'une demi période d'horloge.

Il s'agit là comme le notera l'homme de l'art d'une caractéristique générale des circuits diviseurs par une puissance entière de 2 ($2^q$), où on pourra trouver dans le circuit du diviseur, éventuellement en rajoutant des inverseurs, $2^{q+1}$ signaux de même fréquence, correspondant à la fréquence d'entrée divisée par $2^q$, mais déphasés les uns des autres de $360°/2^{q+1}$.

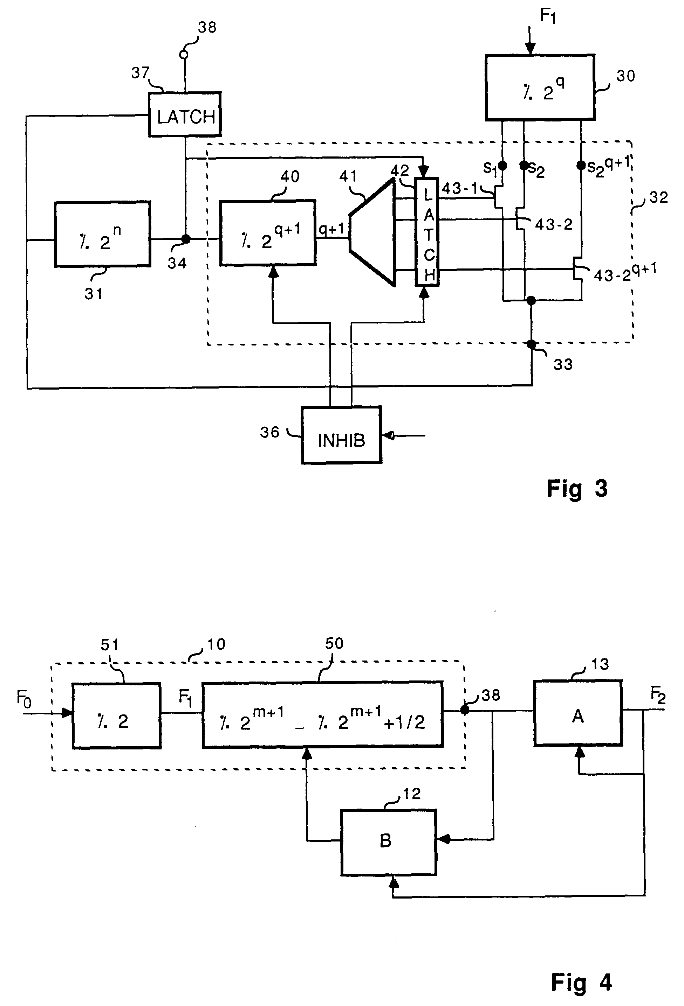

Cette observation liminaire étant faite, on va maintenant décrire un mode de réalisation de la présente invention en relation avec la figure 3.

La figure 3 représente sous forme de blocs un schéma d'un diviseur selon la présente invention. Ce diviseur comprend essentiellement un premier diviseur par $2^q$

30, un deuxième diviseur par $2^n$ 31, et un multiplexeur 32. Les $2^{q+1}$ sorties du diviseur 30, telles que mentionnées en relation avec les figures 2A et 2B, apparaissent sur des bornes $s_1$, $s_2$ ..., $s_2^{q+1}$ et sont fournies séquentiellement par le multiplexeur 32 sur sa sortie 33 qui est appliquée à l'entrée du diviseur 31.

La sortie 34 du diviseur 31 est appliquée à l'entrée de commande ou entrée de séquencement du multiplexeur 32. Ainsi, si l'on considère que le signal d'entrée appliqué à l'entrée du diviseur 30 est à une fréquence F1, on obtiendra a un signal sur la sortie $s_1$ après $2^q$ transitions de polarité donnée du signal F1 puis l'on obtiendra a un signal sur la sortie 34 du diviseur 31 après $2^{q+n}$ impulsions du signal F1. Le signal à la sortie 34 agit sur le multiplexeur de sorte que le multiplexeur sélectionne ensuite en sortie le signal $s_2$ et non plus le signal $s_1$. Le signal $s_2$ étant décalé d'une demi période du signal à la fréquence F1 par rapport au signal $s_1$, on obtient un circuit diviseur par $2^{q+n} + 1/2$.

On peut considérer comme on l'a exposé précédemment que du fait que le décalage entre $s_1$ et $s_2$ dépend d'une seule bascule, le compteur peut compter au rythme du temps de commutation d'une seule bascule. Une autre façon de considérer l'avantage de rapidité du circuit selon l'invention consiste à dire que, étant donné un circuit qui, en l'absence du multiplexeur 32, permettrait d'avoir une résolution d'une période d'horloge, on peut, avec la même technologie, avoir une résolution d'une demi période d'horloge.

Par ailleurs, il est clair que si l'on interrompt le fonctionnement du multiplexeur par l'action d'un circuit d'inhibition 36, on passera d'un fonctionnement en diviseur par $2^{q+n}+1/2$ à un fonctionnement en diviseur par $2^{q+n}$. Il résulte de la structure du circuit selon la présente invention que ce passage de l'un à l'autre des facteurs de division peut se faire sans aucune perte d'information. En effet on dispose pour établir le signal de commande de facteur de division de la durée correspondant à la période du signal F1 multipliée par sensiblement $2^{q+n}$ et non de la seule demi période du signal F1.

La figure 3 indique en outre la présence d'une bascule 37 du type latch entre la sortie 34 du diviseur 31 et la sortie finale 38 du diviseur d'ensemble. Cette bascule 37 reçoit comme signal d'horloge la sortie 33 du multiplexeur, de même que le diviseur 31. La bascule 37 est utilisée de façon classique pour éviter la fourniture de signaux erratiques au moment des transitions de comptage.

La figure 3 illustre en outre un exemple de réalisation schématique du multiplexeur 32. Dans ce mode de réalisation particulier, le multiplexeur 32 comprend un compteur jusqu'à $2^{q+1}$ 40 recevant la sortie 34 du diviseur 31 et dont toutes les sorties de comptage (q+1 sorties) sont transmises à un décodeur 41 qui commande des interrupteurs 43-1, 43-2,..., 43-$2^{q+1}$ disposés entre chacune des sorties $s_1$, $s_2$, ..., $s_{2q+1}$ et la borne de sortie 33 du multiplexeur. Une bascule de type latch 42 recevant comme signal d'horloge le signal au point 34 est de préférence insérée entre le décodeur et les interrupteurs. Dans le mode de réalisation illustré, les interrupteurs 43-1, ..., 43-$2^{q+1}$ ont été représentés sous forme de transistors MOS. Quand on veut passer à un fonctionnement en diviseur par $2^{q+n}$, le circuit d'inhibition 36 susmentionné inhibera simultanément le compteur 40 et la bascule 42 de sorte que, dès que le fonctionnement de ce circuit d'inhibition sera interrompu, on reprendra la commande exactement à l'emplacement de l'interruption pour éviter tout saut de phase quand on passe d'un fonctionnement à division par $2^{q+n}$ à un fonctionnement à division par $2^{q+n}+1/2$.

La figure 4 représente schématiquement le montage d'un diviseur selon la présente invention pour remplacer le diviseur 10 d'un compteur avaleur du type de celui illustré en figure 1. Le compteur selon la présente invention, désigné par la référence 50, sera choisi de sorte que, avec les mêmes notations que celles des figures 1 et 3, n+q = m-1 et sera placé en série avec un diviseur par 2 51. Le diviseur 51 reçoit la fréquence F0 mentionnée en figure et fournit la fréquence F1 mentionnée en figure 3. C'est la sortie 38 du diviseur 50 qui est appliquée aux compteurs 12 et 13 et la sortie du diviseur 12 correspond la fourniture du signal d'inhibition par le circuit d'inhibition 36 de la figure 3.

La présente invention a été décrite de façon schématique et sous forme de blocs, ses différents éléments étant en eux-mêmes classiques et pouvant être réalisés par l'homme de l'art qui pourra d'ailleurs apporter diverses variantes et modifications à ces schémas. Notamment, divers moyens pourront être utilisés pour réaliser le multiplexeur 32 et le circuit selon la présente invention pourra être mis en oeuvre selon diverses technologies de fabrication de circuits intégrés, telles qu'une technologie bipolaire-ECL, ou une technologie MOS ou une technologie mixte MOS/bipolaire.

## Revendications

1. Compteur/diviseur divisant une fréquence d'entrée F1 par $2^{q+n}+1/2$, comprenant:

   un premier diviseur par $2^q$ (30) recevant le signal à diviser de fréquence F1 et fournissant $2^{q+1}$ sorties à la fréquence F1/$2^q$ déphasées les unes par rapport aux autres de 360°/$2^{q+1}$ ;
   un multiplexeur (32) muni d'une borne de commande (34) et fournissant sur sa sortie (33) séquentiellement chacune desdites $2^{q+1}$ sorties chaque fois qu'un signal de commande est appliqué à ladite borne ; et
   un deuxième diviseur par $2^n$ (31) recevant la sortie (33) du multiplexeur et fournissant la sortie (34) recherchée du compteur/diviseur, cette sortie étant appliquée à ladite borne.

2. Compteur/diviseur selon la revendication 1, caractérisé en ce que la sortie (34) du deuxième diviseur est fournie à la borne de sortie (38) du compteur/diviseur par l'intermédiaire d'une bascule à mémorisation (37) séquencée par le signal appliqué au deuxième diviseur.

3. Compteur/diviseur selon la revendication 1, caractérisé en ce qu'il comprend des moyens revevant un signal d'inhibition pour inhiber le fonctionnement du multiplexeur (32), d'où il résulte qu'une même sortie du premier diviseur est en permanence fournie à l'entrée du deuxième diviseur et que le taux de division du compteur/diviseur est de $2^{q+n}$.

4. Compteur/diviseur selon la revendication 1, caractérisé en ce que le multiplexeur comprend un troisième diviseur par $2^{q+1}$ (40) dont toutes les sorties sont décodées par un décodeur (41) et appliquées à une bascule à mémorisation (42) dont les sorties commandent séquentiellement $2^{q+1}$ interrupteurs (43-1, ...,43-$2^{q+1}$) respectivement placés entre chacune des $2^{q+1}$ sorties du premier diviseur et la sortie (33) du multiplexeur.

5. Utilisation d'un compteur/diviseur selon l'une quelconque revendications 3 ou 4 en série avec un diviseur par 2 (51) en tant que diviseur d'entrée d'un compteur programmable du type compteur avaleur comprenant, outre ce diviseur d'entrée, des premier (12) et deuxième (13) compteurs, la sortie du premier compteur constituant le signal d'inhibition modifiant le facteur de division dudit compteur/diviseur.

**Patentansprüche**

1. Zähler/Teiler zum Teilen einer Eingangsfrequenz F1 durch $2^{q+n}$ +1/2, welcher umfaßt:

   einen ersten Teiler durch $2^q$ (30), dem das zu teilende Signal der Frequenz F1 zugeführt wird und der $2^{q+1}$ Ausgangsgrößen der Frequenz $2^q$ erzeugt, die relativ zueinander jeweils um $360°/2^{q+1}$ phasenversetzt sind;

   einen mit einem Steueranschluß (34) versehenen Multiplexer (32), der beim jedesmaligen Anlegen eines Steuersignals an den genannten Anschluß an seinem Ausgang (33) aufeinanderfolgend jeweils jede der genannten $2^{q+1}$ Ausgangsgrößen liefert;

   einen zweiten Teiler durch $2^n$ (31), dem die Ausgangsgröße (33) des Multiplexers zugeführt wird und der die gesuchte Ausgangsgröße (34) des Zähler/Teilers liefert, welche an den genannten Anschluß angelegt wird.

2. Zähler/Teiler nach Anspruch 1, dadurch gekennzeichnet daß die Ausgangsgröße (34) des zweiten Teilers dem Ausgangsanschluß (38) des Zähler/Teilers über einen Kipp- bzw. Flip-Flop-Speicher (37) zugeführt wird, der durch das an den zweiten Teiler angelegte Signal sequenziert wird.

3. Zähler/Teiler nach Anspruch 1, dadurch gekennzeichnet, daß er mit einem Inhibit- bzw. Sperrsignal beaufschlagte Schaltmittel zum Inhibieren bzw. Sperren der Funktion des Multiplexers (32) aufweist, mit der Folge, daß eine selbe Ausgangsgröße des ersten Teilers permanent dem Eingang des zweiten Teilers zugeführt wird und die Teilungsrate des Zähler/Teilers $2^{q+n}$ beträgt.

4. Zähler/Teiler nach Anspruch 1, dadurch gekennzeichnet, daß der Multiplexer einen dritten Teiler durch $2^{q+1}$ (40) aufweist, dessen sämtliche Ausgangsgrößen durch einen Decoder (41) dekodiert und einem Kipp-bzw. Flip-Flop-Speicher (42) zugeführt werden, dessen Ausgänge aufeinanderfolgend $2^{q+1}$ Schalter (43-1,......,43-$2^{q+1}$) steuern, die jeweils zwischen jedem der $2^{q+1}$ Ausgänge des ersten Teilers und dem Ausgang (33) des Multiplexers angeordnet sind.

5. Anwendung eines Zähler/Teilers gemäß einem der Ansprüche 3 oder 4 in Reihe mit einem Teiler durch 2 (51) als Eingangsteiler eines programmierbaren Zählers vom Swallower-Typ, der außer diesem Eingangszähler einen ersten (12) und einen zweiten (13) Zähler aufweist, wobei die Ausgangsgröße des ersten Zählers das Inhibier-bzw. Sperrsignal bildet, welches den Teilungsfaktor des genannten Zähler/Teilers modifiziert.

**Claims**

1. A counter/divider dividing an input frequency F1 by $2^{q+n}$+1/2, comprising:

   a first divider by $2^q$ (30) receiving the signal to divide of frequency F1 and providing $2^{q+1}$ outputs at the frequency $F1/2^q$ out of phase the ones to the others of $360°/2^{q+1}$;
   a multiplexer (32) having a control terminal (34) and sequentially providing at its output (33) each of said $2^{q+1}$ outputs each time a control signal is applied to said terminal; and
   a second divider by $2^n$ (31) receiving the output (33) of the multiplexer and providing the desired output (34) of the counter/divider, this output being applied to said terminal.

2. A counter/divider as claimed in claim 1, characterized in that the output (34) of the second divider is provided to the output terminal (38) of the counter/divider through a latch (37) sequenced by the signal applied to the second divider.

3. A counter/divider as claimed in claim 1, characterized in that it comprises means receiving an inhibition signal to inhibit the operation of the multiplexer (32), whereby a same output of the first divider is permanently provided to the input of the second divider and whereby the division rate of the counter/divider is $2^{q+n}$.

4. A counter/divider as claimed in claim 1, characterized in that the multiplexer comprises a third divider by $2^{q+1}$ (40) all the outputs of which are decoded by a decoder (41) and applied to a latch (42), the outputs of Which sequentially control $2^{q+1}$ switches (43-1, ..., 43-$2^{q+1}$) respectively placed between each of the $2^{q+1}$ outputs of the first divider and the output (33) of the multiplexer.

5. A use of a counter/divider as claimed in claim 3 or 4 in series with a divider by 2 (51) as an input divider of a programmable counter of the swallower counter type comprising, as well as this input divider, first (12) and second (13) counters, the output of the first counter forming the inhibition signal modifying the division factor of said counter/divider.

Fig 1

Fig 2A

Fig 2B

7

Fig 3

Fig 4